# EUROPEAN PATENT APPLICATION

(11) **EP 1 152 532 A2**
(43) Date of publication of application: **07.11.2001**
(21) Application number: 01106747.7
(22) Date of filing: 17.03.2001
(51) Int. Cl.: H03K 17/785

(54) **Mos-gated photo-coupled relay having a reduced turn-on time**

(30) Priority: 12.04.2000 US 547462
(71) Applicant: Infineon Technologies North America Corp., San Jose, CA 95112-6000 (US)
(72) Inventor: Blanchard, Richard A., Los Altos, CA 94024 (US); Whitney, David L., San Jose, CA 95127 (US)
(74) Representative: Patentanwälte Westphal, Mussgnug & Partner

(57) **Abstract**

A photo-coupled solid-state relay (38; 62; 84) and a method of activating the relay utilize a power-conserving technique to reduce the amount of current applied to a light-emitting diode (46; 70; 92) of an optical control circuit (40; 64; 86) of the relay, after the relay has been activated. The power-conserving technique can be used to reduce the turn-on time of the relay and/or reduce the amount of current consumed by the control circuit when the relay is activated. The solid-state relay may be used in a number of high power switching applications, such as a power switch in a modem of a personal computer. The control circuit includes first and second current paths (50 and 52; 74 and 76; 96 and 98) that connect the light-emitting diode to a current source. In operation, input current is conducted through the first and second current paths to the light-emitting diode to activate the output transistors (30 and 32) of the relay. After the output transistors have been activated, an active device (42 and 44; 66; 88) on one of the current paths is turned "off" to reduce the amount of input current applied to the light-emitting diode, while maintaining the output transistors in the activated state.

## Description

### BACKGROUND OF THE INVENTION

The invention relates generally to electrical relays and more particularly to a photo-coupled solid-state relay.

### DESCRIPTION OF THE RELATED ART

Photo-coupled solid-state relays operate to regulate current flow in an output circuit by selectively activating and deactivating a high power switching device such as a power metal-oxide-semiconductor (MOS) transistor, that can handle high voltages and/or large currents. The activation and deactivation of the switching device are controlled by an input current that is electrically isolated from the regulated circuit. Unlike electromechanical relays, there are no moving components in the solid-state relays that can deteriorate over time. As a result, solid-state relays have an increased operating life.

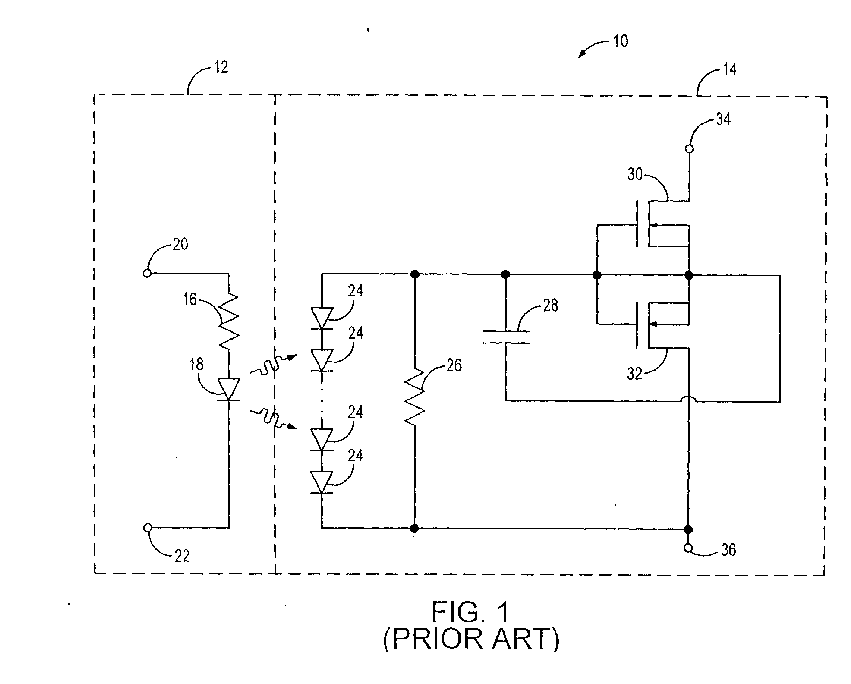

Turning to Fig. 1, a conventional photo-coupled solid-state relay 10 having an optical control circuit 12 and an optically-controlled switching circuit 14 is shown. The control circuit is electrically isolated from the switching circuit, as illustrated by the physical separation between the two circuits. The control circuit includes a current-limiting resistor 16 and a light-emitting diode 18 that are connected in series between a high voltage input terminal 20 and a low voltage input terminal 22. When an input current is allowed to conduct between the input terminals, the light-emitting diode generates light in response to the applied current. The generated light is then utilized by the switching circuit to regulate the current flow in an output circuit (not shown) that is connected to the switching circuit.

The optically-controlled switching circuit 14 of the conventional solid-state relay 10 includes an array of photodiodes 24, a resistor 26, a capacitor 28 and a pair of serially-connected output MOS transistors 30 and 32. The array of photodiodes is electrically coupled to the gates of the output transistors. In addition, the array of photodiodes is optically coupled to the light-emitting diode 18 of the control circuit 12 to receive the light generated by the light-emitting diode. The received light is utilized by the photodiodes to produce photocurrent to charge the gates of the output transistors, so that the voltage created by the photocurrent can activate the output transistors. The capacitor 28 represents the gate capacitance of the output transistors. The two output transistors are connected in series between a high voltage output terminal 34 and a low voltage output terminal 36. The output transistors operate as a switch to regulate the current flow between the two output terminals. The resistor 26 is connected to the gates of the output transistors and to the low voltage output terminal to discharge the electrical energy stored in the capacitor 28 to reduce the turn-off time of the relay 10, i.e. the turn-off time of the output transistors 30 and 32.

To activate the solid-state relay 10, input current is allowed to conduct through the current limiting resistor 16 and to the light-emitting diode 18 of the control circuit 12. The light-emitting diode then generates light in response to the input current. The generated light causes the optically-coupled photodiodes 24 of the switching circuit 14 to produce photocurrent. Since the photodiodes 24 are electrically coupled to the gates of the output transistors 30 and 32, the photocurrent charges the gates of the output transistors, so that the voltage at the gates turns "on" the output transistors. When the output transistors are turned "on," the output current is allowed to flow between the high voltage output terminal 34 and the low voltage output terminal 36.

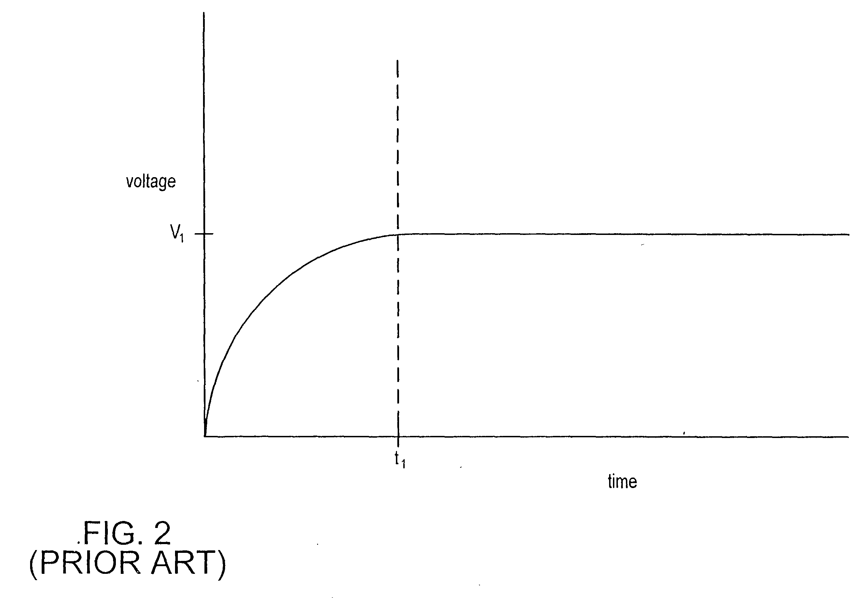

Due to the non-linear characteristic of the gate capacitance 28 of the output MOS transistors 30 and 32, which is illustrated in Fig. 2, the turn-on time of the MOS transistors is determined by the amount of photocurrent produced by the photodiodes 24 of the switching circuit 14. With reference to Fig. 2, assuming that V₁ is the required gate voltage to turn "on" the output transistors, the time that is required to reach V₁ is t₁. Thus, the turn-on time of the output transistors is t₁. However, if the photocurrent generated by the photodiodes is increased, the V₁ can be reached in a shorter period, and consequently, the turn-on time of the output MOS transistors can be reduced.

One technique to increase the amount of photocurrent generated by the photodiodes 24 of the switching circuit 14 is to increase the amount of light incident on the photodiodes by intensifying the light from the light-emitting diode 18 of the control circuit 12. The intensified light would induce the photodiodes to produce a larger photocurrent, which would then increase the voltage at the gates of the output transistors more rapidly. A disadvantage of such technique is that more power is required by the light-emitting diode of the control unit to supply the intensified light, during the entire period when the output transistors are turned "on". In a battery-operated system, the power dissipation due to the increased light output can significantly reduce the battery-operated life of the system.

In light of the above disadvantage, what is needed is a photo-coupled solid-state relay having a reduced turn-on time without increased power consumption to maintain the turned-on state of the relay.

### SUMMARY OF THE INVENTION

A photo-coupled solid-state relay and a method of activating the relay utilize a power-conserving technique to reduce the amount of current applied to a light-emitting diode of an optical control circuit of the relay, after the relay has been activated. The power-conserving technique can be used to reduce the turn-on time of the relay and/or reduce the amount of current consumed by the control circuit when the relay is activated. The solid-state relay may be used in a number of high power switching applications, such as a power switch in a modem of a personal computer.

The photo-coupled solid-state relay includes an optically-controlled switching circuit and the optical control circuit. The switching circuit may be one of a number of conventional switching circuits. In an exemplary embodiment, the switching circuit includes an array of photodiodes that is electrically connected to the gates of two serially-connected output MOS transistors. The output transistors are power devices that are positioned between a high voltage output terminal and a low voltage output terminal to control the conduction through the output terminals.

The optical control circuit of the solid-state relay includes the light-emitting diode that is electrically connected between a high voltage input terminal and a low voltage input terminal, e.g., electrical ground. The light-emitting diode is optically coupled to the photodiodes of the switching circuit. Although the optical control circuit is electrically isolated from the switching circuit, the control circuit can optically control the output MOS transistors of the switching circuit to turn "on" the output transistors, thereby activating the solid-state relay. During an activation procedure, input current is applied to the light-emitting diode of the control circuit. The light-emitting diode then generates light in response to the applied current. Since the light-emitting diode is optically coupled to the photodiodes of the switching circuit, the light generated by the light-emitting diode impinges upon the array of photodiodes, causing the photodiodes to produce photocurrent. The photocurrent then charges the gates of the output MOS transistors. When the voltage at the gates of the output transistors reaches a threshold voltage, the output transistors are turned "on".

The optical control circuit of the relay also includes circuitry to reduce the amount of input current applied to the light-emitting diode of the control circuit, after the output transistors have been turned "on". However, a sufficient amount of input current is still applied to the light-emitting diode to optically cause the photodiodes of the switching circuit to produce enough photocurrent to maintain the output MOS transistors in the activated state. The amounts of initial input current and subsequently reduced input current applied to the light-emitting diode can be adjusted to customize the performance of the solid-state relay. The amount of initial current applied to the light-emitting diode can be increased to reduce the turn-on time of the output MOS transistors. Alternatively, the amount of initial current applied to the light-emitting diode can be maintained at a conventional level, which would result in a reduced power consumption by the control circuit of the relay.

In a first embodiment, the circuitry to reduce the amount of input current applied to the light-emitting diode of the optical control unit includes a pair of MOS transistor that are connected in series between a current source, i.e., the high voltage input terminal, and the light-emitting diode. The gates of the two MOS transistors are electrically connected to a bias circuit that controls the conductivity of the MOS transistors. To activate the output transistors of the switching circuit, the bias circuit transmits control signals to turn "on" both MOS transistors. During this initial period, the input current is conducted through both MOS transistors to the light-emitting diode, which activates the output transistors of the switching circuit, as described above. After the output transistors have been activated, the bias circuit selectively removes a control signal to turn "off" one of the MOS transistors. This causes the input current to be drawn through only one MOS transistor, which reduces the amount of input current applied to the light-emitting diode.

In a second embodiment, the circuitry to reduce the amount of input current includes a depletion mode MOS transistor and a resistor. The depletion mode MOS transistor is located on a first current path from the current source to the light-emitting diode, while the resistor is located on a second current path from the current source to the light-emitting diode. Thus, the MOS transistor and the resistor are connected in parallel. The gate of the depletion mode MOS transistor is connected to the bias circuit. To activate the output transistors of the switching circuit, the depletion mode MOS transistor is set to the conduction state and input current is allowed to conduct through both the first and second current paths to the light-emitting diode, which results in the activation of the output transistors. After the output transistors have been activated, the bias circuit removes a control signal to turn "off" one of the depletion mode MOS transistors. This causes the input current to be drawn through only the resistor on the second current path, which reduces the amount of input current applied to the light-emitting diode.

In a third embodiment, the depletion mode MOS transistor is replaced with a bipolar transistor. In this embodiment, the bipolar transistor is initially activated by a control signal to the base of the bipolar transistor from the bias circuit. After the output transistors of the switching circuit are activated, the bias circuit removes the control signal, turning "off" the bipolar transistor. Once the bipolar transistor is deactivated, the input current is drawn through only the resistor of the second current path.

An advantage of the invention is that by allowing an increased amount of input power to be applied to the light-emitting diode of the control circuit, the turn-on time of the solid-state relay can be reduced. Furthermore, since the power consumption of the control circuit is reduced during the entire period when the relay is in the activated state, the overall power consumption of the solid-state relay can be decreased.

### BRIEF DESCRIPTION OF THE DRAWINGS

Fig. 1 is a schematic of a prior art photo-coupled solid-state relay.

Fig. 2 is a graph of voltage over time for the gate capacitance of MOS transistors of the solid-state relay of Fig. 1.

Fig. 3 is a schematic of a photo-coupled solid-state relay in accordance with a first embodiment of the present invention.

Fig. 4 is a schematic of a photo-coupled solid-state relay in accordance with a second embodiment of the invention.

Fig. 5 is a schematic of a photo-coupled solid-state relay in accordance with a third embodiment of the invention.

Fig. 6 is a flow diagram of a method of activating a photo-coupled solid-state relay in accordance with the invention.

### DETAILED DESCRIPTION

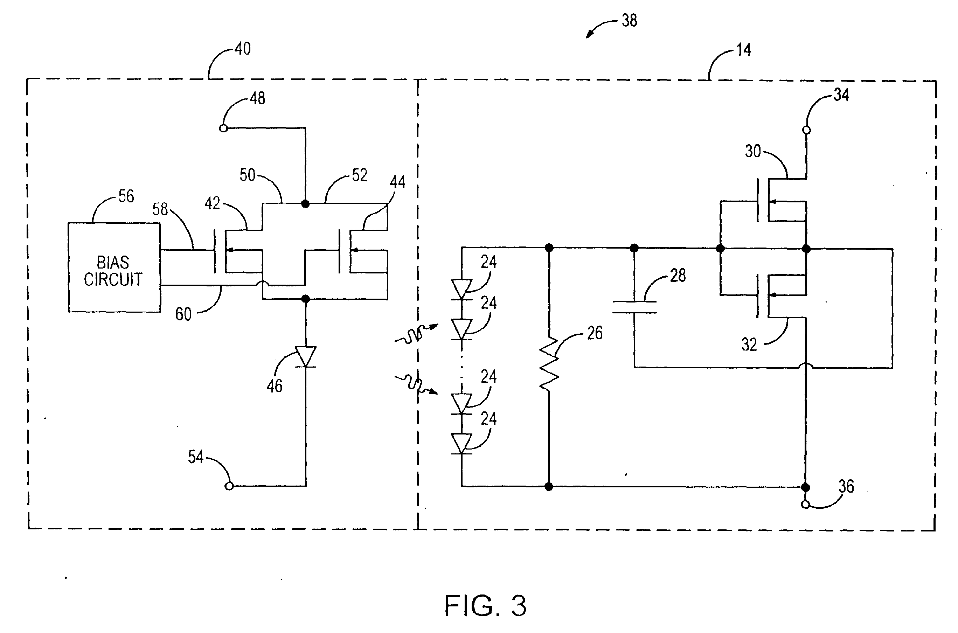

With reference to Fig. 3, a photo-coupled solid-state relay 38 in accordance with a first embodiment of the present invention is shown. The solid-state relay operates in a manner that can reduce the turn-on time of the relay and/or reduce the power consumption of the relay during the period when the relay is turned "on". The solid-state relay may be used in a number of high power switching applications, such as a power switch in a modem of a personal computer.

The photo-coupled solid-state relay 38 of Fig. 3 includes the optically-controlled switching circuit 14, which is a component of the conventional photo-coupled solid-state relay 10 of Fig. 1. However, the solid-state relay 38 of Fig. 3 may incorporate one of a number of conventional optically-controlled switching circuits, instead of the switching circuit 14. The exact configuration of the switching circuit included in the solid-state relay 38 is not critical to the invention.

The optically-controlled switching circuit 14 includes the array of photodiodes 24, the resistor 26, the capacitor and the pair of output MOS transistors 30 and 32. The switching circuit operates to regulate current flow between the high voltage output terminal 34 and the low voltage output terminal 36 by selectively activating and deactivating the output transistors that connect the two output terminals. The activation and deactivation of the output transistors are controlled by the photodiodes that charge the gates of the output transistors by transmitting photocurrent that is generated when the photodiodes are exposed to incident light. The capacitor 28 represents the gate capacitance of the output MOS transistors. The two output MOS transistors are connected in series between the high voltage output terminal and the low voltage output terminal. The resistor 26 is connected to the gates of the output transistors and to the low voltage output terminal to discharge the electrical energy stored in the capacitor when the relay is being turned "off" to reduce the deactivation time of the output MOS transistors.

The photo-coupled solid-state relay 38 also includes an optical control circuit 40. The control circuit is comprised of two enhancement mode MOS transistors 42 and 44 and a light-emitting diode 46. The MOS transistors are connected in parallel between a high voltage input terminal 48 and the light-emitting diode. The MOS transistor 42 is located on a first current path 50, while the MOS transistor 44 is located on a second current path 52. The MOS transistor 42 controls the current flow through the first current path. Similarly, the MOS transistor 44 controls the current flow through the second current path. The light-emitting diode 46 is connected between the two MOS transistors and a low voltage input terminal 54, which may be electrical ground.

The control circuit 40 further includes a bias circuit 56 that is electrically connected to the gates of the MOS transistors 42 and 44. The bias circuit is coupled to the gates of the MOS transistors 42 and 44 by electrical connections 58 and 60, respectively. The bias circuit can activate the MOS transistor 42 to the conducting state by transmitting a first control signal to the gate of the MOS transistor 42 through the electrical connection 58. Similarly, the bias circuit can activate the MOS transistor 44 by transmitting a second control signal to the gate of the MOS transistor 44 through the electrical connection 60. Since the MOS transistors regulate the current flow through their respective current path, the bias circuit can control the amount of current supplied to the light-emitting diode 46 by selectively activating and deactivating the MOS transistors. When both MOS transistors are turned "on," a large amount of current is supplied to the light-emitting diode. However, when only one of the MOS transistors is turned "on," a significantly reduced amount of current is supplied to the light-emitting diode.

The activation procedure of the solid-state relay 38 is initiated when the bias circuit 56 of the optical control circuit 40 transmits the first and second control signals to the gates of the MOS transistors 42 and 44. The control signals turn "on" both MOS transistors, which allows current to flow from the high voltage input terminal 48 to the light-emitting diode 46 through both the first and second current paths 50 and 52. Thus, the light-emitting diode 46 receives a large amount of current. In response, the light-emitting diode generates light with an intensity that is proportional to the amount of current received by the light-emitting diode. That is, an increased amount of current results in an increased light output from the light-emitting diode. The generated light is then received by the optically coupled array of photodiodes 24 of the switching circuit 14 that produces photocurrent in response to the received light. The amount of photocurrent generated by the photodiodes is proportionally related to the intensity of the received light.

Since the array of photodiodes 24 is electrically connected to the gates of the output MOS transistors 30 and 32, the generated photocurrent charges the gates of the output transistors. When the voltage at the gates of the output transistors reaches a threshold voltage, the output transistors are switched to the conducting state, thereby allowing current to flow between the output terminals 34 and 36. Due to the gate capacitance of the output transistors, which is schematically represented by the capacitor 28 in Fig. 3, a short period of time is required to raise the voltage at the gates to the threshold voltage that will activate the output transistors. The duration of the required time is dependent on the amount of photocurrent applied to the gates of the output MOS transistors. A higher level of photocurrent generated by the photodiodes equates to a shorter duration of the required time to activate the output transistors. However, once the output transistors are turned "on," a smaller amount of current is required to maintain the charge (or voltage) on the gates of the output transistors. Therefore, after the output transistors are activated to the conducting state, one of the MOS transistors 42 and 44 of the optical control circuit 40 is turned "off" by the bias circuit 56, such that current is conducted through only the current path 50 or 52, depending on which MOS transistor is deactivated. This can be accomplished by removing one of the control signals that were applied to the gates of the MOS transistors 42 and 44, which reduces the amount of current received by the light-emitting diode 46. In response, the light output of the light-emitting diode is decreased, which in turn reduces the amount of photocurrent generated by the photodiodes 24 of the switching circuit 14. Since a smaller amount of current is required to maintain the charge on the gates of the output transistors 30 and 32 of the switching circuit 14, the reduction in the generated photocurrent does not deactivate the output transistors to the non-conducting state. Consequently, the amount of current supplied to the light-emitting diode 46 of the control circuit 40 is significantly reduced from the initial amount of current when both MOS transistors 42 and 44 were conducting current to the light-emitting diode, thereby reducing the amount of current consumed by the control circuit.

The amounts of initial current and subsequent reduced current applied to the light-emitting diode 46 of the control circuit 40 can be adjusted to customize the performance of the solid-state relay 38. The turn-on time of the solid-state relay can be shortened by allowing a greater amount of initial current to be transmitted to the light-emitting diode when both MOS transistors 42 and 44 are in the conducting state, as compared to the amount of initial current transmitted to light-emitting diodes of conventional solid-state relays, such as the solid-state relay 10 of Fig. 1. The increased amount of current induces the light-emitting diode 46 of the control circuit 40 to generate a more intense light, which in turn causes the photodiodes 24 of the switching circuit 14 to produce an increased amount of photocurrent. This increased amount of photocurrent charges the capacitor 28 more quickly and consequently, reduces the turn-on time of the output MOS transistor 30 and 32.

However, if the amount of initial current applied to the light-emitting diode 46 of the control circuit 40 is not increased, the power consumption of the solid-state relay 38 can be significantly decreased without increasing the turn-on time of the solid-state relay 38. Since the control circuit 40 operates to reduce the amount of current applied to the light-emitting diode after the output MOS transistors 30 and 32 of the switching circuit 14 are turned "on," the power consumption of the control circuit is reduced during the entire period when the output transistors are turned "on". Thus, the overall power consumption of the solid-state relay can be reduced.

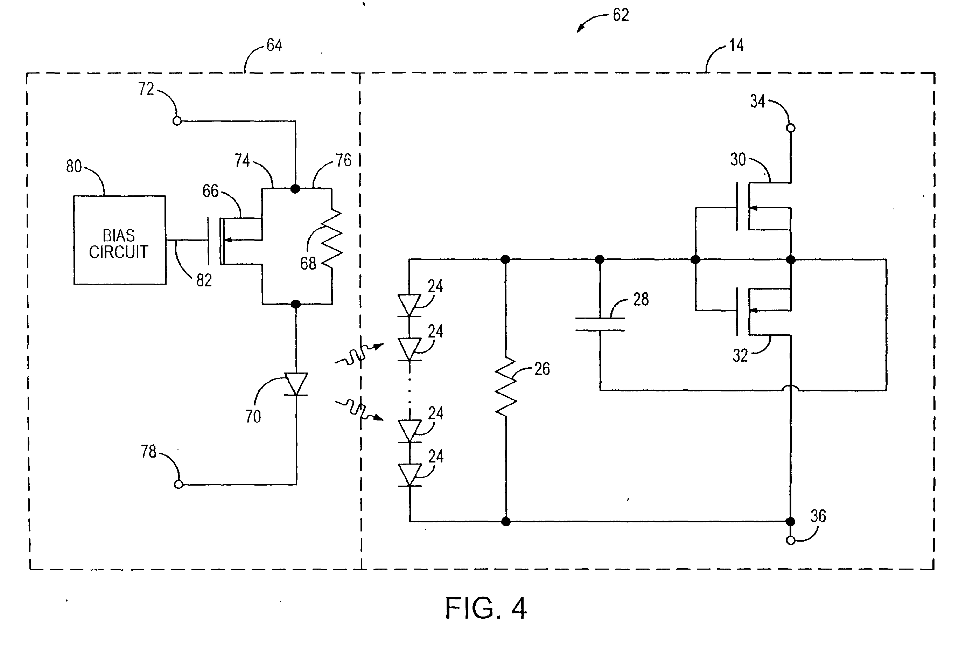

Turning now to Fig. 4, a photo-coupled solid-state relay 62 in accordance with a second embodiment of the invention is shown. Similar to the solid-state relay 38 of Fig. 3, the photo-coupled solid-state relay 62 is also shown to include the optically controlled switching circuit 14, which is a component of the conventional photo-coupled solid-state relay 10 of Fig. 1. However, the solid-state relay 62 may incorporate one of a number of conventional optically-controlled switching circuits, instead of the switching circuit 14.

The photo-coupled solid-state relay 62 includes an optical control circuit 64. The control circuit is comprised of a depletion mode MOS transistor 66, a resistor 68 and a light-emitting diode 70. The MOS transistor and the resistor are connected in parallel between a high voltage input terminal 72 and the light-emitting diode. The MOS transistor 66 is located on a first current path 74, while the resistor 68 is located on a second current path 76. The MOS transistor 66 controls the current flow through the first current path. The light-emitting diode 70 is connected between a low voltage input terminal 78, which may be electrical ground, and the parallel-coupled MOS transistor 66 and resistor 68.

The control circuit 64 further includes a bias circuit 80 that is electrically connected to the gate of the depletion mode MOS transistor 66 by an electrical connection 82. The bias circuit operates to deactivate the depletion mode MOS transistor to a non-conducting state to control the current flow through the first current path 74. The MOS transistor is deactivated when the bias circuit transmits a control signal to the gate of the MOS transistor via the electrical connection 82. Thus, the bias circuit can control the amount of current supplied to the light-emitting diode 70 through the first current path by selectively activating and deactivating the MOS transistor. When the MOS transistor is in the conducting state, a large amount of current is supplied to the light-emitting diode 70 though both the first and second current paths 74 and 76. However, when the MOS transistor is deactivated, a significantly reduced amount of current is supplied to the light-emitting diode through only the second current path.

The activation procedure executed by the photo-coupled solid-state relay 62 is similar to that of the solid-state relay 38 of Fig. 3 in that, initially, input current is allowed to be conducted through both the first and second current paths 74 and 76 of the control circuit 64 to the light-emitting diode 70 to turn "on" the output MOS transistors 30 and 32 of the switching circuit 14. After the output MOS transistors are turned "on," the input current is not allowed to conduct through one of the current paths of the control circuit. In the case of the photo-coupled solid-state relay 62, the input current is not allowed to conduct through the first current path 74 by deactivating the depletion mode MOS transistor 66 to the non-conducting state. During the initial period when the output MOS transistors 30 and 32 of the switching circuit 14 are not activated, the depletion mode MOS transistor 66 is set to the conducting state, i.e., no voltage is applied to the gate of the MOS transistor by the bias circuit 80. This allows the input current to conduct through the first current path, as well as the second current path 76. After the output MOS transistors are turned "on," the bias circuit 80 transmits a control signal to the gate of the depletion mode MOS transistor 66 to turn "off" the transistor, thereby allowing the input current to conduct only through the second current path. The result is a reduction of input current applied to the light-emitting diode 70. The described operation of the photo-coupled solid state relay 62 can reduce the turn-on time of the relay and/or reduce the amount of power consumed by the control circuit of the relay, depending on the amounts of initial input current and subsequently reduced input current applied to the light-emitting diode 70 of the control circuit 64.

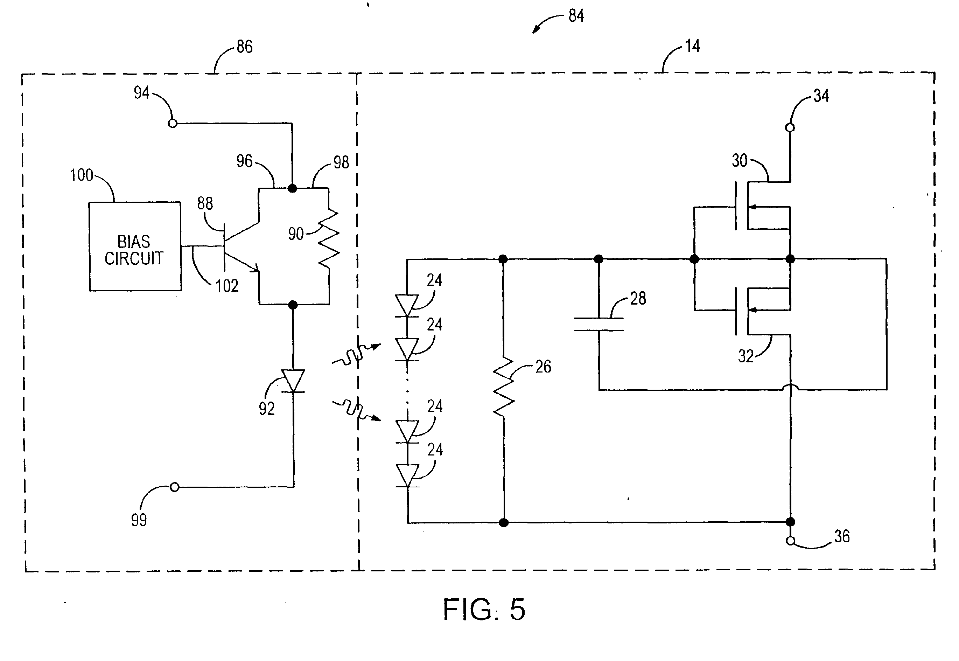

Turning to Fig. 5, a photo-coupled solid-state relay 84 in accordance with a third embodiment of the invention is shown. Similar to the solid-state relays 38 and 62 of Figs. 3 and 4, the photo-coupled solid-state relay 84 is also shown to include the optically controlled switching circuit 14, which is a component of the conventional photo-coupled solid-state relay 10 of Fig. 1. However, the solid-state relay may incorporate one of a number of conventional optically-controlled switching circuits, instead of the switching circuit 14.

The photo-coupled solid-state relay 84 includes an optical control circuit 86. The control circuit is comprised of a bipolar transistor 88, a resistor 90 and a light-emitting diode 92. The bipolar transistor and the resistor are connected in parallel between a high voltage input terminal 94 and the light-emitting diode. The bipolar transistor is located on a first current path 96, while the resistor is located on a second current path 98. The bipolar transistor controls the current flow through the first current path. The light-emitting diode is connected between a low voltage input terminal 99, which may be electrical ground, and the parallel-coupled bipolar transistor 88 and resistor 90.

The control circuit 86 further includes a bias circuit 100 that is electrically connected to the base of the bipolar transistor 88 by an electrical connection 102. The bias circuit operates to activate the bipolar transistor to the conducting state by transmitting a control signal to the base of the bipolar transistor via the electrical connection 102. Thus, the bias circuit can control the amount of current supplied to the light-emitting diode 92 through the first current path by selectively activating and deactivation the bipolar transistor. When the bipolar transistor is in the conducting state, a large amount of current is supplied to the light-emitting diode though both the first and second current paths 96 and 98. However, when the bipolar transistor is deactivated, a significantly reduced amount of current is supplied to the light-emitting diode through only the second current path.

The activation procedure executed by the photo-coupled solid-state relay 84 is similar to the procedure executed by the solid-state relay 62 of Fig. 4. Initially, input current is allowed to be conducted through both the first and second current paths 96 and 98 of the control circuit 86 to the light-emitting diode 92 to turn "on" the output MOS transistors 30 and 32 of the switching circuit 14. During this initial period when the output MOS transistors are not activated, the bias circuit 100 transmits a control signal to the base of the bipolar transistor 88 through the electrical connection 102 to activate the bipolar transistor, which allow the input current to conduct through the first current path. After the output MOS transistors are turned "on," the bias circuit removes the control signal from the base of the bipolar transistor, deactivating the bipolar transistor. The deactivation of the bipolar transistor forces the input current to conduct through only the second current path via the resistor 90. The result is a reduction of input current applied to the light-emitting diode. The described operation of the photo-coupled solid state relay 84 can reduce the turn-on time of the relay and/or reduce the amount of power consumed by the control circuit of the relay, depending on the initial input current and subsequently reduced input current applied to the light-emitting diode 92 of the control circuit 86.

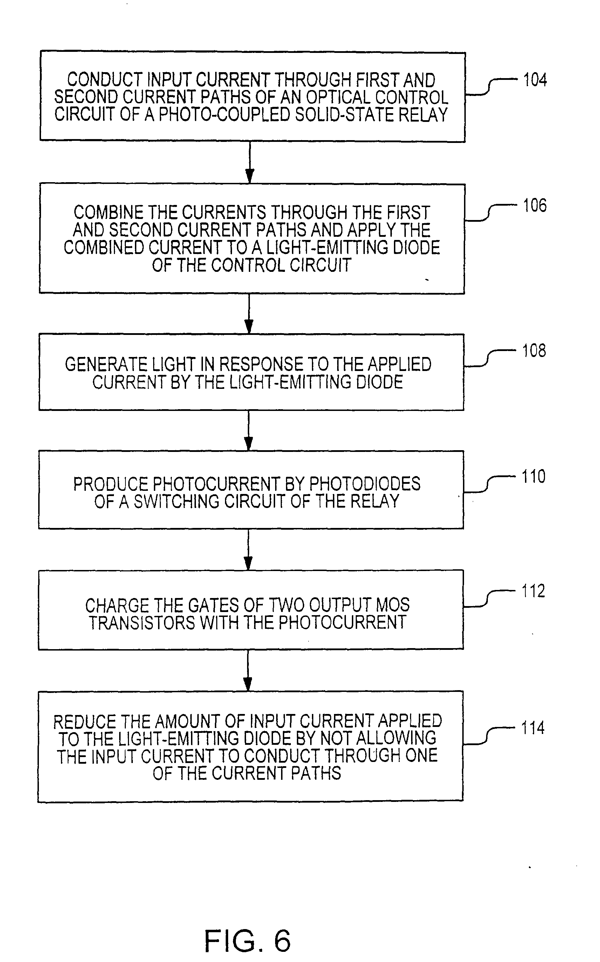

A method of activating a photo-coupled solid-state relay in accordance with the present invention will be described with reference to Fig. 6. During step 104, input current is conducted through first and second current paths of an optical control circuit of the solid-state relay. The currents through the first and second current paths are then combined and applied to a light-emitting diode of the control circuit, during step 106. At step 108, the light-emitting diode generates light in response to the applied current. The generated light then causes photodiodes of a switching circuit of the relay that are optically-coupled to the light-emitting diode to produce photocurrent, during step 110. The photocurrent charges the gates of serially-connected output MOS transistors of the switching circuit, thereby turning "on" the output transistors, during step 112. After the output transistors are turned "on," the amount of input current applied to the light-emitting diode of the control circuit is reduced by not allowing the input current to conduct through one of the current paths of the control circuit, during step 114. In a first embodiment, the amount of input current applied to the light-emitting diode is reduced by turning "off" an enhancement mode MOS transistor that controls the current flow through either the first current path or the second current path of the control circuit. In a second embodiment, the reduction of input current is achieved by turning "off" a depletion mode MOS transistor that controls the current flow through the first current path of the control circuit. In a third embodiment, the reduction of input current is achieved by turning "off" a bipolar transistor that controls the current flow through the first current path of the control circuit.

## Claims

1. An optical control circuit (40; 64; 86) for a solid-state relay (38; 62; 84) comprising:
a light-emitting device (46; 70; 92) connected to a current source, said light-emitting device being configured to generate light when subjected to applied current, said generated light being used to turn on said solid-state relay;
a first electrical element (42; 66; 88) located on a first current path (50; 74; 96) between said current source and said light-emitting device;
a second electrical element (44; 68; 90) located on a second current path (52; 76; 98) between said current source and said light-emitting device, said second current path being parallel to said first current path; and
a bias circuit (56; 80; 100) coupled to said first electrical element for controlling the conduction through said first electrical element to selectively reduce a current flow through said first current path, said reduced current flow causing said light-emitting device to generate said light in a lowered intensity without turning off said solid-state relay, thereby reducing an amount of current used by said light-emitting device to maintain said solid-state relay in a turned-on state.

2. The optical control circuit of claim 1 wherein said first electrical element (42; 66; 88) includes a first transistor (42; 66; 88) having a first control electrode, said first control electrode of said first transistor being electrically coupled to said bias circuit (56; 80; 100) so that a conductive state of said first transistor can be controlled by said bias circuit.

3. The optical control circuit of claim 2 wherein said second electrical element (44) includes a second transistor (44) having a second control electrode, said second control electrode of said second transistor being electrically coupled to said bias circuit (56; 80; 100) so that a conductive state of said second transistor can be controlled by said bias circuit (56).

4. The optical control circuit of claim 1 or 2 wherein said second electrical element (68 and 90) includes a resistor (68 and 90).

5. The optical control circuit of claim 4 wherein said first electrical element (42 and 66) includes a metal-oxide-semiconductor transistor (42 and 66).

6. A method of activating a solid-state relay (38; 62; 84) comprising steps of:
conducting (104) input current through first and second current paths (50 and 52; 74 and 76; 96 and 98) to a light-emitting device (46; 70; 92) such that said input current from both said first and second current paths are applied to said light-emitting device, said first and second current paths being parallel to each other;
generating (108) light by said light-emitting device, said light having an intensity proportionally related to said input current applied to said light-emitting device;
activating (110 and 112) said solid-state relay in response to said generated light, said activation of said solid-state relay allowing an output current to flow between a high voltage terminal (34) and a low voltage terminal (36); and
reducing (114) an amount of said input current applied to said light-emitting device, after said solid-state relay has been activated, by decreasing said input current conducted through one of said first and second current paths.

7. The method of claim 6 wherein said step (114) of reducing said amount of said input current includes a step of deactivating a transistor (42; 66; 88) located on said first current path (50; 74; 96), said deactivation of said transistor substantially preventing said input current from being conducted through said first current path.

8. The method of claim 7 wherein said step of deactivating said transistor (42; 66; 88) is a step of deactivating a depletion mode metal-oxide-semiconductor transistor (66) located on said first current path (74).

9. The method of claim 7 wherein said step of deactivating said transistor (42; 66; 88) is a step of deactivating a bipolar transistor (88) located on said first current path (96).

10. The method of claim 7 wherein said step of deactivating said transistor (42; 66; 88) is a step of deactivating an enhancement mode metal-oxide-semiconductor transistor (42) located on said first current path (50).
